(19) Europäisches Patentamt / European Patent Office / Office européen des brevets

(11) **EP 3 307 468 B1**

(12) **EUROPÄISCHE PATENTSCHRIFT**


(45) Veröffentlichungstag und Bekanntmachung des Hinweises auf die Patenterteilung:
**01.05.2024 Patentblatt 2024/18**

(21) Anmeldenummer: **16753242.3**

(22) Anmeldetag: **14.06.2016**

(51) Internationale Patentklassifikation (IPC):
***B23K 3/08*** $^{(2006.01)}$ ***B23K 20/26*** $^{(2006.01)}$

(52) Gemeinsame Patentklassifikation (CPC):
**B23K 3/08; B23K 20/26**

(86) Internationale Anmeldenummer:
**PCT/DE2016/100271**

(87) Internationale Veröffentlichungsnummer:
**WO 2016/202327 (22.12.2016 Gazette 2016/51)**


(54) **AUTOMATISCHE BONDKRAFTKALIBRIERUNG**

AUTOMATIC BOND FORCE CALIBRATION

CALIBRATION AUTOMATIQUE DE LA FORCE DE LIAISON


(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.06.2015 DE 102015109485**
**08.06.2016 DE 102016110590**

(43) Veröffentlichungstag der Anmeldung:
**18.04.2018 Patentblatt 2018/16**



(73) Patentinhaber: **Hesse GmbH**
**33104 Paderborn (DE)**

(72) Erfinder:
- **WALTHER, Frank**
**33100 Paderborn (DE)**
- **HESSE, Hans-Jürgen**
**33106 Paderborn (DE)**
- **JOCHHEIM, Andreas**
**33100 Paderborn (DE)**

(74) Vertreter: **Wickord, Wiro**
**Wickord Buser Patentanwälte PartG mbB**
**Rathenaustraße 96**
**33102 Paderborn (DE)**



(56) Entgegenhaltungen:
**JP-A- 2002 118 136**
**KR-A- 20000 066 062**
**KR-B1- 100 604 328**
**US-A- 6 119 917**



Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



EP 3 307 468 B1

## Beschreibung

Die Erfindung betrifft ein Kalibrierverfahren für einen Bonder, bei dem eine Charakteristik für einen Kraftaktuator des Bonders messtechnisch erfasst und so abgespeichert wird, dass auf Basis der messtechnisch erfassten Daten der Kraftaktuator im Produktionsbetrieb des Bonders optimal angesteuert werden kann. Ferner betrifft die Erfindung eine Vorrichtung zur vollautomatischen oder teilautomatischen Bondkraftkalibrierung.

In der industriellen Praxis werden Halbleiterbauelemente mit einem Trägersubstrat durch elektrisch leitende Drähte verbunden, die durch Thermo-Kompression, Thermosonic oder unter Ultraschall mit dem Trägersubstrat verschweißt werden (TC-, TS- oder US-Bonden). Während des Bond- beziehungsweise Schweißvorgangs werden die elektrisch leitenden Drähte mit einem definierten Kraftverlauf auf einen Kontaktpunkt (Bondpad) des Substrats gedrückt. Um dies zu gewährleisten, ist in einem Bondkopf des Bonders neben einer Feder ein zusätzlicher Kraftaktuator vorgesehen zum Halten eines Bondwerkzeugs. Die auf das Bondwerkzeug wirkende Bondkraft entspricht dann der Summe aus der Federkraft und der Kraftwirkung des Kraftaktuators (Aktuatorkraft). Während des Bondens wird der Draht verformt, so dass sich die Position des Bondwerkzeugs während des Bondvorgangs ändert. Unabhängig von der Position des Bondwerkzeugs muss jedoch die Bondkraft weiterhin dem definierten, von der Zeit abhängenden Kraftverlauf folgen. Hierzu ist der Kraftaktuator während des Bondens in geeigneter Weise anzusteuern.

Während allgemein die Federkraft eine Funktion der (Feder-)Auslenkung ist, ist die Aktuatorkraft eine Funktion des eingeprägten Stroms und der Auslenkung. Die Bondkraft muss mit einer Genauigkeit von zirka 1 cN für Dünndrahtbonder und zirka 5 cN für Dickdrahtbonder (Drahtdurchmesser > 100 mm) aufgebracht werden. Entscheidend für das Erreichen der Genauigkeit ist hierbei die genaue Kenntnis über die Zusammenhänge zwischen der Bondkraft und der Auslenkung und dem Strom einerseits und die Robustheit und Genauigkeit der zugehörigen Kalibrierroutine für den Kraftaktuator andererseits.

Bei der Verwendung normaler Spiralfedern zum Halten des Bondwerkzeugs besteht ein linearer Zusammenhang zwischen der Auslenkung und der Federkraft. Die Aktuatorkraft eines Voicecoil-Aktuators ist linear verknüpft mit dem Strom, allerdings nicht ortsunabhängig. Die Nichtlinearität durch die Ortsabhängigkeit wird heute üblicherweise durch die Messungen von Strom, Auslenkung und Bondkraft in drei Kalibrierpunkten und der Berechnung eines geeigneten Polynoms ausgeglichen. Die Bestimmung der Messwerte erfolgt dabei unter Verwendung einer Messeinrichtung zur Bestimmung der Bondkraft, insbesondere einer Waage, in einem bestimmten, dafür vorgesehenen Betriebsmodus (Kalibriermodus beziehungsweise -verfahren) des Bonders unter Einbindung des Maschinenbedieners interaktiv. Für die Messung müssen die zu betrachtenden Kalibrierpunkte stabil eingestellt sein, das heißt die Achsen dürfen sich während des Mess- und Eingabeintervalls nicht bewegen und der Strom des Kraftaktuators muss konstant sein. Der Benutzer ermittelt insofern nach dem Positionieren des Bondkopfs durch Ablesen einer optischen Anzeige der Kraftmesseinrichtung den Kraftwert für die Bondkraft und gibt diesen über Eingabemittel ein, eine Steuerung des Bonders übernimmt den Kraftwert und speichert nach Bestätigung der Eingabe zusätzlich den aktuellen Positionswert, welcher einer bestimmten Auslenkung der Feder entspricht, sowie den in den Kraftaktuator eingeprägten Strom. Die Auslenkung und der Strom werden zusammen mit dem Kraftwert abgespeichert.

Zwischen dem Ablesen des Messwerts und der Eingabe in die Steuerung durch den Benutzer vergeht eine größere Zeitspanne von bis zu einigen Sekunden, was im Fall einer nicht konstanten Position des Bondwerkzeugs dazu führt, dass die Steuerung nicht das korrekte Wertetriple aus Strom, Auslenkung und Bondkraft speichert. Diese Ungenauigkeit hat heute Einfluss auf die Genauigkeit des Bondverfahrens und die Qualität des Bondergebnisses.

Bislang werden in Dickdrahtbondern im Wesentlichen Aluminiumdrähte verarbeitet, bei denen Anpresskräfte von maximal 200 cN erforderlich sind. In modernen Anlagen werden zunehmend Kupferdrähte für die Kontaktierung verwendet, da diese hinsichtlich der Stromtragfähigkeit, der Haltbarkeit und der Temperaturfestigkeit viele Vorteile gegenüber Aluminiumdrähten aufweisen. Allerdings sind die erforderlichen Kräfte beim Bonden bei Verwendung von Kupferdrähten gleichen Durchmessers auf bis zu 5.000 cN angestiegen. Die zur Aufbringung dieser Bondkräfte verwendeten Kraftaktuatoren sind regelmäßig nicht mehr linear. Die Kennlinie muss insofern als Funktion des Orts beziehungsweise der Auslenkung aufgenommen werden. Ferner sind die Bondkräfte bei der Auslenkung der in Biegegelenken gelagerten Bondwerkzeuge nicht mehr linear abhängig von der Auslenkung. Gleichwohl muss auch hier mit derselben Präzision eine Kalibrierung des Kraftaktuators hinsichtlich der Kraftwirkung auf die Schweißstelle durchgeführt werden. Dieses erfordert unter Umständen die Erfassung von deutlich mehr Messwerten in entsprechend mehr Kalibrierpunkten, so dass die Anwendung der bisherigen, manuellen Kalibriermethode aufgrund der Forderung, die Messung statisch durchzuführen, erheblich länger dauert. Bei starker Nichtlinearität können bereits geringe Schwankungen die Messwerte unzulässig stark verändern.

Ein weiteres Problem ergibt sich dadurch, dass insbesondere in modernen Doppelkopf-Bondautomaten der zur Verfügung stehende Platz ein stabiles Positionieren einer externen Kraftmesseinrichtung, insbesondere einer Waage nicht mehr zulässt. Dieses Messgerät wird heute während der Dauer des Kalibriervorgangs temporär in einem Bondbereich des Bonders vorgesehen.

Die US 6 119 917 A beschreibt eine Kalibriervorrichtung für einen Bonder und ein Kalibrierverfahren, bei dem eine Messeinrichtung temporär für die Dauer des Kalibriervorgangs unterhalb des Bondwerkzeugs positioniert wird und ein Kraftmesswert von einer separaten Anzeigeeinheit der Kalibriervorrichtung angezeigt wird. Zur Interaktion mit dem Bonder ist eine Eingabe- beziehungsweise Bedieneinheit vorgesehen. Weiterhin sind aus der KR 2000 0066062 A und der JP 2002 118136 A Bonder bekannt, bei dem der Bondkopf in einem Arbeitsbereich und außerhalb eines Bondbereichs des Bonders positioniert werden kann.

Die Aufgabe der vorliegenden Erfindung ist es insofern, ein verbessertes Kalibrierverfahren für einen Bonder und einen zur Durchführung des Verfahrens ausgebildeten Bonder anzugeben.

Zur Lösung der Aufgabe weist die Erfindung die Merkmale des Patentanspruchs 1 auf. Insofern umfasst das erfindungsgemäße Kalibrierverfahren für einen Bonder mit einem Bondkopf, wobei ein als Teil des Bondkopfs vorgesehenes Bondwerkzeug über eine Feder und einen Kraftaktuator gehalten ist, mit einem Stromsensor zum Erfassen eines zur Ansteuerung des Kraftaktuators verwendeten Stroms, mit einem Positionssensor zum Erfassen einer Auslenkung der Feder, mit einer Steuerung und mit einer Messeinrichtung zur Bestimmung einer Bondkraft die folgenden Verfahrensschritte:

- In einem Positionierschritt wird der Bondkopf so in einem Arbeitsbereich und außerhalb eines Bondbereichs des Bonders positioniert, dass das Bondwerkzeug oberhalb einer messtechnisch wirksamen Kontaktfläche eines Betätigungselements der Messeinrichtung vorgesehen ist;

- in einem Kontaktschritt wird der Bondkopf abgesenkt und das Bondwerkzeug an die Kontaktfläche der Messeinrichtung angesetzt;

- in einem Messschritt wird auf die messtechnisch wirksame Kontaktfläche der Messeinrichtung eine erste Druckkraft aufgeprägt, dann werden zeitgleich oder zeitversetzt in einem mindestens quasi-statischen Betriebszustand des Bonders die Bondkraft mittels der Messeinrichtung, die Auslenkung der Feder mittels des Positionssensors und der Strom mittels des Stromsensors erfasst und es werden aus der Auslenkung, einer Federkennlinie der Feder und der Bondkraft eine Aktuatorkraft und/oder eine Federkraft bestimmt;

- in einem Speicherschritt werden die Messwerte für die Auslenkung und den Strom einerseits sowie die Bondkraft und/oder die Federkraft und/oder die Aktuatorkraft andererseits einem der Steuerung zugeordneten Speicher zugeführt und dort gespeichert;

- der Messschritt und der Speicherschritt werden für wenigstens eine zweite Druckkraft wiederholt durchgeführt.

Erfindungsgemäß werden hierbei die mittels der Messeinrichtung bestimmten Werte für die Bondkraft, die mittels des Positionssensors bestimmten Werte der Auslenkung der Feder und der mittels des Stromsensors bestimmte Strom für den Kraftaktuator automatisiert erfasst und ohne manuelle Eingaben beziehungsweise Zutun des Maschinenbedieners datentechnisch der Steuerung zugeführt und gespeichert. Das Verfahren zur Kalibrierung des Kraftaktuators verzichtet demzufolge auf die heute üblichen manuellen Arbeitsschritte. Insbesondere muss der Kraftmesswert vom Maschinenbediener nicht abgelesen und über Eingabemittel der Steuerung manuell zugeführt werden. Das Kalibrierverfahren kann demzufolge schneller durchgeführt werden, wodurch sich hinsichtlich der Messgenauigkeit signifikante Vorteile gegenüber dem manuellen Verfahren ergeben. Insbesondere ist einer unzulässig großen, die Messwerte verfälschenden Positionsänderung während des Messvorgangs durch die Automatisierung des Verfahrens entgegengewirkt. Ferner ist einer Fehleingabe durch den Maschinenbediener wirkungsvoll vorgebeugt.

Im Sinne der Erfindung ist der Arbeitsbereich des Bonders der Bereich, in dem der Bondkopf verfahren beziehungsweise positioniert werden kann. Ein Bondbereich des Bonders ist der Teilbereich des Arbeitsbereichs, in dem während des Produktionsbetriebs die Halbleiterbauelemente auf das Trägersubstrat gebondet werden können. Es ist insofern so, dass der Arbeitsbereich regelmäßig größer ist als der Bondbereich. Zudem ist die Nomenklatur so gewählt, dass mittels des Bondwerkzeugs zunächst abstrakt eine Druckkraft auf die Messeinrichtung aufgebracht wird. Auf diese Druckkraft wird nach ihrer zahlenmäßigen Erfassung durch die Messeinrichtung als Bondkraft Bezug genommen. Ein zumindest quasi-statischer Betriebszustand im Sinne der Erfindung ist dann erreicht, wenn die Betriebsparameter des Bonders in Bezug auf die Druckkraft beziehungsweise Bondkraft, den Strom und die Auslenkung der Feder während der Dauer der Messwerterfassung keinen Schwankungen oder jedenfalls keinen unzulässig hohen Schwankungen unterliegen, welche zu einer Verfälschung des Messergebnisses führen dahingehend, dass die im Rahmen des Kalibrierverfahrens bestimmten Messwerte nicht zur Ansteuerung des Kraftaktuators während des Produktivbetriebs geeignet sind, da die vorgegebenen Kraftverläufe nicht ausreichend genau eingestellt werden können und die geforderte Bondqualität nicht erreicht wird.

Beispielsweise können der Messschritt und der Speicherschritt nach der Erfindung sequentiell abgearbeitet werden. Es wird dann zunächst der Messschritt durchgeführt und es werden dann nach der Bestimmung aller Messwerte im nachfolgenden Speicherschritt die Messwerte in den Speicher abgelegt. Optional werden die Messwerte vor der Speicherung in die Steuerung nachverarbeitet. Alternativ kann vorgesehen sein, dass der Messschritt und der Speicherschritt für die gleiche Druckkraft zeitlich überschneidend durchgeführt werden. Es werden dann beispielsweise erste Messwerte bestimmt, welche dann in dem Speicher abgelegt werden, während gleichzeitig weitere Messwerte ermittelt werden, die dann nachfolgend abgespeichert werden. Es ist hierbei insofern nicht vorgesehen, dass zunächst alle Messwerte bestimmt und diese Messwerte anschließend gespeichert werden.

Die messtechnisch bestimmte Bondkraft ist definiert als Summe der Aktuatorkraft und der Federkraft. Es ist hierbei möglich, aus der Bondkraft über die messtechnisch bestimmte Auslenkung und die bekannte Federkennlinie der Feder die Federkraft und schließlich aus der Differenz der Bondkraft und der Federkraft die Aktuatorkraft zu bestimmen.

Nach dem erfindungsgemäßen Verfahren kann vorgesehen sein, die Bondkraft und die Aktuatorkraft und die Federkraft für die verschiedenen Kalibrierpunkte abzulegen. Ebenso kann vorgesehen sein, dass nur die Bondkraft oder nur die Aktuatorkraft gespeichert wird, da über geeignete Algorithmen aus der Bondkraft oder aus der Aktuatorkraft die jeweils nicht gespeicherten Kraftwerte berechnet werden können. Ebenso kann auch vorgesehen sein, die Bondkraft und die Federkraft oder die Bondkraft und die Aktuatorkraft oder die Aktuatorkraft und die Federkraft zu speichern.

Nach der Erfindung wird der Bondkopf in dem Positionierschritt außerhalb des Bondbereichs des Bonders positioniert. Korrespondierend hierzu wird die Messeinrichtung in dem Arbeitsbereich des Bonders und ebenfalls außerhalb des Bondbereichs des Bonders vorgesehen. Vorteilhaft besteht hierdurch die Möglichkeit, die Messeinrichtung zu einem fest verbauten Teil des Bonders vorzubilden, welche dauerhaft im Bonder verbleibt und nicht temporär während der Durchführung der Kalibrierung des Kraftaktuators in dem Bondbereich des Bonders positioniert und nach der Durchführung des Kalibriervorgangs entfernt werden muss. Die Positionierung des Bondkopfs beziehungsweise der Messeinrichtung im Arbeitsbereich des Bonders und außerhalb des Bondbereichs des Bonders gestattet es insofern, die Messeinrichtung über eine Datenleitung dauerhaft mit der Steuerung des Bonders zu verbinden, da der Bondbereich für die Aufnahme des Trägersubstrats und die Durchführung des Bondverfahrens während des Produktionsbetriebs unverändert und uneingeschränkt zur Verfügung steht. Ebenfalls kann eine dauerhafte Energieversorgung der Messeinrichtung seitens des Bonders realisiert werden.

Nach einer Weiterbildung der Erfindung werden je aufgeprägtem Strom für den Kraftaktuator wenigstens vier und bevorzugt zehn oder mehr unterschiedliche Auslenkungen angefahren und die Bondkräfte für die unterschiedlichen Auslenkungen mittels der Messeinrichtung bestimmt. Vorteilhaft kann durch die Aufnahme von vier oder mehr unterschiedlichen Auslenkungen für einen gleichen Strom ein in Bezug auf die unterschiedlichen Auslenkungen sehr genaues Kennfeld für den Kraftaktuator ermittelt werden. In der Folge können auch Kraftaktuatoren mit einer in Bezug auf die Auslenkung bei einem konstanten Strom nichtlinearen Charakteristik sehr genau und feinfühlig angesteuert werden, so dass der Kraftverlauf während des Bondvorgangs entsprechend der Vorgaben gestaltet und die Bondqualität erhöht werden.

Nach einer Weiterbildung der Erfindung werden je Auslenkung wenigstens vier und bevorzugt zehn oder mehr unterschiedliche Ströme für den Kraftaktuator aufgeprägt und die Bondkräfte für die unterschiedlichen Ströme mittels der Messeinrichtung bestimmt. Vorteilhaft kann durch die Bestimmung von wenigstens vier unterschiedlichen Strömen je Auslenkung eine Charakteristik des Kraftaktuators in vorteilhafter Weise sehr genau bestimmt werden. In der Folge kann anhand der Charakteristik des Kraftaktuators während des Produktionsbetriebs der Kraftverlauf exakt gestaltet werden. Hierdurch ergibt sich eine signifikante Verbesserung der Bondqualität insbesondere für Kraftaktuatoren mit einer bezogen auf den Strom nichtlinearen Charakteristik.

Nach der Erfindung kann ebenfalls vorgesehen sein, dass die Charakteristik des Kraftaktuators kennfeldartig für unterschiedliche Auslenkungen und unterschiedliche Ströme bestimmt wird. Es ist hierdurch regelmäßig notwendig, eine große Anzahl von Kalibrierpunkten anzusteuern und eine Vielzahl von Messwerten zu erfassen. Die Messpunkte können aufgrund der Automatisierung des Verfahrens und des Verzichts auf die manuelle Eingabe der Kraftwerte durch den Maschinenbediener schnell und zuverlässig, das heißt insbesondere in der geforderten Genauigkeit und frei von Eingabefehlern ermittelt werden.

Nach einer Weiterbildung der Erfindung kann bei der Durchführung des Kalibrierverfahrens eine der Federkraft entgegenwirkende Aktuatorkraft aufgeprägt werden, indem das Bondwerkzeug gegen ein Zugwerkzeug mit einem Haken ausgetauscht und der Haken des Zugwerkzeugs in eine an dem Betätigungselement der Messeinrichtung vorgesehene Öse eingehakt wird. Es kann dann eine definierte Auslenkung so eingestellt und der Strom für den Aktuator so aufgeprägt werden, dass die Federkraft der Aktuatorkraft entgegenwirkt. Vorteilhaft kann hierdurch das Kennfeld für einen bidirektional wirkenden Kraftaktuator, das heißt einen zur Aufprägung von Druckkräften und Zugkräften ausgebildeten Kraftaktuator mittels des erfindungsgemäßen Kalibrierverfahrens bestimmt werden. Während des Produktionsbetriebs ist es dann möglich, die durch die Auslenkung der Feder wirkende Kraft bei einer vorgegebenen Werkzeugposition zu reduzieren.

Nach einer Weiterbildung der Erfindung werden für einen gegebenen Strom des Kraftaktuators sowie für eine erste Auslenkung und wenigstens eine zweite Auslenkung ein erster Kraftzunahmewert und ein zweiter Kraftzunahmewert gebildet als Quotient aus der Aktuatorkraft und dem Strom. Durch die Bestimmung des von der Auslenkung abhängigen Kraftzunahmewerts kann für den Fall, dass bei einer gegebenen Auslenkung die Kraft linear mit dem Strom zunimmt, die Bondkraft während des Betriebsverfahrens in besonders einfacher Weise bestimmt werden. Insbesondere kann die Bondkraft als Produkt der von der Auslenkung abhängigen Federkraft und dem Produkt des ebenfalls von der Auslenkung abhängigen Kraftzunahmewerts und dem Strom ermittelt werden. Die Bestimmung des Kraftzunahmewerts führt insofern bei Kraftaktuatoren, deren Aktuatorkraft bei einer gegebenen Auslenkung linear vom Strom abhängt, zu einer besonders einfachen und schnellen Kalibrierung und zu einer einfachen Ansteuerung im Produktionsbetrieb.

Zur Lösung der Aufgabe weist die Erfindung die Merkmale des Patentanspruchs 8 auf. Es ist insofern vorgesehen, eine Vorrichtung zur vollautomatischen oder teilautomatischen Bondkraftkalibrierung eines Bonders mit einem Bondkopf, wobei ein als Teil des Bondkopfs vorgesehenes Bondwerkzeug über eine Feder und einen Kraftaktuator gehalten ist, umfassend eine in einem Arbeitsbereich des Bonders und außerhalb eines Bondbereichs des Bonders montierte Kraftmessdose als Messeinrichtung zum Bestimmen einer Bondkraft, wobei die Kraftmessdose jedenfalls von einem an dem Bondkopf des Bonders vorgesehenen Bondwerkzeug als Kraftbeaufschlagungskomponente mit einer Druckkraft und bevorzugt mit einer Druckkraft und mit einer Zugkraft beaufschlagbar ist, wobei die Kraftmessdose datentechnisch mit einer Steuerung des Bonders verbunden derart, dass Messwerte der Kraftmessdose an die Steuerung des Bonders übertragen und dort weiterverarbeitet beziehungsweise gespeichert werden, umfassend ein datentechnisch mit der Steuerung verbundenen Positionssensor zum Erfassen einer Auslenkung der Feder, umfassend ein datentechnisch mit der Steuerung verbundenen Stromsensor zum Erfassen eines Stroms des Kraftaktuators und umfassend einen als Teil der Steuerung ausgebildeten Speicher zum Speichern der Messwerte der Kraftmessdose und/oder des Positionssensors und/oder des Stromsensors und/oder einer aus der gemessenen Bondkraft und der Auslenkung der Feder bestimmten Aktuatorkraft und/oder einer Federkraft.

Vorteilhaft ergibt sich durch die erfindungsgemäße Vorrichtung die Möglichkeit, den Kalibriervorgang des Kraftaktuators vollautomatisch oder teilautomatisch durchzuführen. Es kann insbesondere ein die Bondkraft, die Auslenkung und den Strom umfassendes Wertetriple zeitgleich oder innerhalb eines sehr kurzen Zeitintervalls bestimmt werden mit der Folge, dass die Charakteristik des Kraftaktuators mit sehr hoher Genauigkeit ermittelt und in der Folge der Bondprozess optimiert gestaltet werden kann. Bei der vollautomatischen Kalibrierung des Kraftaktuators kann insbesondere vorgesehen sein, dass eine Kalibrierroutine gestartet und ohne weitere manuelle Eingriffe eine vollständige Kennfeldermittlung durchgeführt wird, in denen unterschiedliche Auslenkungen für die Feder eingestellt und/oder Ströme für den Kraftaktuator aufgeprägt und jeweils die Bondkraft ermittelt wird. Als Teil der vollautomatischen Kalibrierung wird der Positionierschritt durchgeführt, indem eine bekannte und auf die Position der Messeinrichtung im Arbeitsbereich des Bonders abgestimmte Position für den Bondkopf angefahren und der Bondkopf dann in Richtung der Messeinrichtung abgesenkt wird. Bei der teilautomatischen Bondkraftkalibrierung kann vorgesehen sein, dass ein erster Kalibrierpunkt eingestellt und ein Messwerttriple aus Bondkraft, Strom und Auslenkung für den erstem Kalibrierpunkt automatisch ohne manuelles Zutun des Maschinenbedieners erfasst wird und dass dann eine manuelle Eingabe beziehungsweise Bestätigung des Bedieners notwendig ist, um nach dem ersten Mess- und Speicherschritt einen zweiten Kalibrierpunkt einzustellen und die Messwertermittlung zu wiederholen.

Nach einer Weiterbildung der Erfindung ist als Kraftmessdose eine Messvorrichtung mit einem unter der Druckkraft verformbaren Biegebalken vorgesehen. Vorteilhaft erlaubt es das Vorsehen des Biegebalkens, die Kraftmessdose in konstruktiv besonders einfacher Weise robust und langlebig zu gestalten und zugleich die Werte für die Bondkraft ausreichend präzise zu ermitteln. Es können beispielsweise zur Bestimmung der Kraft Dehnungsmessstreifen verwendet oder eine Auslenkung des Biegebalkens optisch erfasst werden.

Nach einer Weiterbildung der Erfindung weist die Kraftmessdose ein Betätigungselement mit einer Kontaktfläche auf. Über die Kontaktfläche wird mittels des Bondwerkzeugs die Druckkraft auf die Kraftmessdose aufgeprägt. Zusätzlich kann eine Öse vorgesehen sein, um auf die Kraftmessdose eine Zugkraft aufzuprägen. Zum Aufprägen der Zugkraft kann das Bondwerkzeug gegen ein Zugwerkzeug ausgetauscht werden, wobei das Zugwerkzeug einen die Öse einsetzbaren Haken aufweist.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination im Rahmen der Ansprüche erfindungswesentlich sein. Erfindungsgemäß beschriebene Merkmale und Details der Vorrichtung gelten selbstverständlich auch im Zusammenhang mit dem erfindungsgemäßen Verfahren und umgekehrt. So kann auf die Offenbarung zu den einzelnen Erfindungsaspekten stets im Rahmen der Ansprüche wechselseitig Bezug genommen werden.

Die Zeichnungen dienen lediglich beispielhaft der Klarstellung der Erfindung und haben keinen einschränkenden Charakter.

Es zeigen:

Fig. 1 eine perspektivische Ansicht einer Messeinrichtung zur Bestimmung einer Bondkraft eines Bonders,

Fig. 2 einen prinzipiellen inneren Aufbau der Messeinrichtung nach Fig. 1,

Fig. 3 eine Anordnung der Messeinrichtung nach Fig. 1 in einem Arbeitsbereich des Bonders,

Fig. 4 eine im Zuge der Kalibrierung mit einem erfindungsgemäßen Kalibrierverfahren ermitteltes erstes Kennfeld für eine Aktuatorkraft und eine Federkraft und

Fig. 5 ein weiteres, mit dem erfindungsgemäßen Kalibrierverfahren ermitteltes Kennfeld zur Kalibrierung des Bonders.

Eine zur Bestimmung einer Bondkraft eingesetzte Messeinrichtung 1 nach den Figuren 1 und 2 sieht ein Gehäuse 2 mit einer Ausnehmung 3 und eine Verbindungsleitung 4 vor. Die Verbindungsleitung 4 dient zum einen der Energieversorgung der Messeinrichtung 1 und zum anderen der datentechnischen Verbindung der Messeinrichtung 1 mit einer Steuerung eines Bonders. Insbesondere kann die Energieversorgung der Messeinrichtung 1 unmittelbar durch den Bonder erfolgen.

Die Messeinrichtung 1 sieht als messtechnisch wirksame Komponente einen einseitig eingespannten Biegebalken 5 vor, an dem ein Betätigungselement 6 festgelegt ist. Das Betätigungselement 6 ragt abschnittsweise durch die Ausnehmung 3 aus dem Gehäuse 2 der Messeinrichtung 1. Das Betätigungselement 6 weist außerhalb des Gehäuses 2 eine im Wesentlichen eben ausgebildete Kontaktfläche 7 auf, an welche ein nicht dargestelltes Bondwerkzeug des Bonders angesetzt wird zum Aufprägen einer Druckkraft. Das Bondwerkzeug ist dabei als Teil eines Bondkopfs des Bonders realisiert und in einer entsprechenden Aufnahme des Bondkopfs gehalten.

An dem Biegebalken 5 der Messeinrichtung 1 ist ein Messwertaufnehmer 8, insbesondere ein Dehnungsmessstreifen festgelegt. Der Messwertaufnehmer 8 ist über einen flexiblen Leiter mit einer Elektronik 9 der Messeinrichtung 1 verbunden. Es kann insofern durch eine Betätigung der Messeinrichtung 1, das heißt das Auftreten einer Druckkraft auf die Kontaktfläche 7 aus einer Durchbiegung des Biegebalkens 5 eine Druckkraft (Bondkraft) erfasst werden.

Optional kann vorgesehen sein, dass an dem Betätigungselement 6 eine Öse vorgesehen ist. Die Öse ist bevorzugt im Bereich der Kontaktfläche 7 oder statt der Kontaktfläche 7 vorgesehen. Durch das Vorsehen der Öse kann bei Verwendung eines Zugwerkzeugs anstelle des Bondwerkzeugs mit einem Haken des Zugwerkzeugs die Öse gegriffen werden. Es ist insofern möglich, zusätzlich zu einer Federkraft mittels eines Kraftaktuator eine Zugkraftkomponente aufzuprägen, welche der Federkraft entgegenwirkt und/oder von der Messeinrichtung 1 erfasst wird.

Figur 3 zeigt die Anordnung der Messeinrichtung 1 in einem Arbeitsbereich 10 des Bonders. Der Arbeitsbereich des Bonders ist dadurch gekennzeichnet, dass in eben diesem der den Kraftaktuator aufweisender Bondkopf des Bonders frei positioniert werden kann. Die Anordnung der Messeinrichtung 1 in dem Arbeitsbereich 10 des Bonders ist dabei so gewählt, dass die Messeinrichtung 1 außerhalb eines Bondbereichs 11 vorgesehen ist. Der Bondbereich 11 ist dabei der Teilbereich des Arbeitsbereichs 10 des Bonders, in dem im Produktivbetrieb die Halbleiterbauelemente auf das Trägersubstrat gebondet werden.

Die Anordnung der Messeinrichtung 1 außerhalb des Bondbereichs 11 gewährleistet, dass die Messeinrichtung 1 fest angeordnet und dauerhaft verbaut werden kann, ohne die Nutzbarkeit des Bonders im Produktivbetrieb zu beschränken. Beispielsweise kann vorgesehen sein, dass außerhalb des Bondbereichs der Positionierung des Bondkopfs mit einer Genauigkeit erfolgt, welche für das Bonden unzureichend ist, aber gleichwohl gewährleistet, dass das Bondwerkzeug mit ausreichender Genauigkeit oberhalb der Kontaktfläche 7 der Messeinrichtung 1 positioniert ist.

Die Durchführung des erfindungsgemäßen Kalibrierverfahrens für den Bonder wird nachfolgend zunächst unter Bezugnahme auf ein erstes Kennfeld nach Figur 4 diskutiert. Hierbei ist es so, dass der Bondkopf in einem Positionierschritt oberhalb der messtechnisch wirksamen Kontaktfläche 7 der Messeinrichtung 1 in einem Arbeitsbereich und außerhalb eines Bondbereichs des Bonders positioniert wird. In einem Kontaktschritt wird der Bondkopf abgesenkt und an die Kontaktfläche 7 abgelegt. Anschließend wird in einem Messschritt eine betragsmäßig zunächst nicht erfasste erste Druckkraft auf die Messeinrichtung aufgeprägt, wobei dann zeitgleich oder zeitversetzt in einem quasi-statischen Betriebszustand des Bonders mittels der Messeinrichtung 1 die Bondkraft und mittels eines Positionssensors des Bonders eine Auslegung einer als Teil des Bondkopfs realisierten und zum Halten des Bondwerkzeugs vorgesehenen Feder und mittels eines Stromsensors des Bonders ein Strom erfasst wird, welcher auf den Kraftaktuator des Bonders aufgeprägt wird. Das Bondwerkzeug ist dabei über die Feder und den Kraftaktuator gehalten. Die Bondkraft bestimmt sich insofern als Summe aus der Aktuatorkraft des Kraftaktuators und der Federkraft. In einem Speicherschritt werden die Messwerte für die Auslegung und den Strom einerseits sowie die Bondkraft beziehungsweise die Federkraft beziehungsweise die Aktuatorkraft andererseits einem der Steuerung des Bonders zugeordneten Speicher zugeführt und dort abgespeichert. Schließlich werden der Messschritt und der Speicherschritt für eine Vielzahl von weiteren Kalibrierpunkten durchgeführt. Es können insofern die Auslenkung und/oder der Strom variiert werden.

Für die verschiedenen Kalibrierpunkte werden in dem Kennfeld nach Figur 4 die entsprechenden Bondkraftwerte abgelegt. Es ist insofern so, dass exemplarisch vierzehn Werte für den Strom und vierzehn Werte für die Auslenkung der Feder erfasst und in einer Matrix zusammen mit der Federkraft abgelegt werden. Die Federkraft bestimmt sich hierbei bei bekannter Federkennlinie aus der messtechnisch mit Hilfe des Positionssensors erfassten Auslenkung.

Da nun aufgrund der Bestimmung des Kennfelds während der Kalibrierung die Charakteristik des Kraftaktuators bekannt ist, können nun im Produktivbetrieb die zur Erzielung eines geforderten, definierten Kraftverlaufs beim Bonden erforderlichen Betriebsparameters für den Bonder aus den Kalibrierdaten berechnet und aufgeprägt beziehungsweise eingestellt werden. Wenn die Kraftwirkung des Kraftaktuators betragsmäßig unabhängig von der Stromrichtung ist, können die Kräfte des gesamten Prozessbereichs unmittelbar aus den für positive Ströme bestimmten Kalibrierdaten berechnet werden. Ein positiver Strom entspricht hierbei einer Aktuatordruckkraft und ein negativer Strom einer Aktuatorzugkraft.

Nach einer alternativen Ausführungsform des Kalibrierverfahrens können für positive Ströme und negative Ströme getrennte Bondkräfte ermittelt werden. Dies ist insbesondere dann erforderlich, wenn der Kraftaktuator für positive Ströme einer gegebenen Stromstärke und negative Ströme der gleichen Stromstärke nicht die gleiche entgegengesetzte Kraft bereitstellt. In diesem Fall muss üblicherweise das Bondwerkzeug gegen ein Zugwerkzeug ersetzt werden. An dem Zugwerkzeug ist dann der Haken vorgesehen, welcher in einer an dem Betätigungselement der Messeinrichtung 1 vorgesehene Öse eingesetzt wird zum Aufprägen von durch den Kraftaktuator bereitgestellten Zugkraftkomponenten.

Nach einer weiteren alternativen Ausführungsform des Kalibrierverfahrens werden für den Fall, dass die in Bezug auf den Strom, die Auslenkung oder die Bondkraft bestimmten Messwerte abhängig sind von den vorhergehenden Prozesszuständen (Hysterese), zusätzlich zu den aktuellen Messwerten die Vorgängerwerte mit gespeichert. Es ist so in Abhängigkeit von der Vorgeschichte die Bestimmung der Bondkräfte möglich mit der Folge, dass während des Produktivbetriebs unter Berücksichtigung der Vorgeschichte die definierten Kraftverläufe eingestellt werden können.

Nach einer weiteren alternativen Ausführungsform des Kalibrierverfahrens werden für den Fall, dass zur Erzielung der geforderten Genauigkeit ein Einfluss der Temperatur auf die Messwerte berücksichtigt werden muss, die Kennfelder um die Dimension der Temperatur erweitert. Die Temperatur wird dann für verschiedene und bevorzugt für alle Messwerte beziehungsweise Wertetriple aus Strom, Auslenkung und Bondkraft mit abgespeichert. Die Temperatur kann beispielsweise direkt über zusätzlich angebrachte Sensoren bestimmt oder indirekt aus einem thermodynamischen Modell ermittelt beziehungsweise geschätzt werden.

Alternativ kann eine vereinfachte Ausführungsform des Kalibrierverfahrens Verwendung finden, wenn bei einer gegebenen Auslenkung die Aktuatorkraft linear mit dem Strom zunimmt. Zunächst wird hierbei, wie in Figur 5 beschrieben, für ausgewählte Kalibrierpunkte die durch Einprägung des Stroms gezeigte Aktuatorkraft als Funktion des Stroms erfasst. Eine Veränderung des Bondkopfs in einzelnen Kalibrierpunkten ergibt sich dann als Steigung einer geraden Gleichung, wobei ein von der Auslenkung abhängiger Kraftzunahmewert m bestimmt ist als Quotient aus der Aktuatorkraft und dem Strom. Die Bondkraft während des Betriebs kann dann ermittelt werden als Summe der Aktuatorkraft und der Federkraft aus der Gleichung

$$F_{Bond}(z) = m(z) \cdot i + F_{Feder}(z),$$

wobei z als Bezugnahme auf die Auslenkung und i als der aufgeprägte Strom zu verstehen ist.

## Patentansprüche

1. Kalibrierverfahren für einen Bonder mit einem Bondkopf, wobei ein als Teil des Bondkopfs vorgesehenes Bondwerkzeug über eine Feder und einen Kraftaktuator gehalten ist, mit einem Stromsensor zum Erfassen eines zur Ansteuerung des Kraftaktuators verwendeten Stroms, mit einem Positionssensor zum Erfassen einer Auslenkung der Feder, mit einer Steuerung und mit einer Messeinrichtung (1) zum Bestimmen einer Bondkraft, umfassend die folgenden Verfahrensschritte:

   - in einen Positionierschritt wird der Bondkopf so in einem Arbeitsbereich (10) und außerhalb eines Bondbereichs (11) des Bonders positioniert, dass das Bondwerkzeug oberhalb einer Kontaktfläche (7) eines Betätigungselements (6) der Messeinrichtung (1) vorgesehen ist;
   - in einem Kontaktschritt wird der Bondkopf abgesenkt und das Bondwerkzeug an die Kontaktfläche (7) der Messeinrichtung (1) eingesetzt;
   - in einem Messschritt wird auf die messtechnisch wirksame Kontaktfläche (7) der Messeinrichtung (1) eine erste Druckkraft aufgeprägt, dann werden zeitgleich oder zeitversetzt in einem mindestens quasi-statischen Betriebszustand die Bondkraft mittels der Messeinrichtung, die Auslenkung der Feder mittels des Positionssensors und der Strom mittels des Stromsensors erfasst und es werden aus der Auslenkung, einer Federkennlinie der Feder und der Bondkraft eine Aktuatorkraft und/oder eine Federkraft bestimmt;
   - in einem Speicherschritt werden die Messwerte für die Auslenkung und den Strom einerseits sowie die Bondkraft und/oder die Federkraft und/oder die Aktuatorkraft andererseits einem der Steuerung zugeordneten Speicher zugeführt und dort gespeichert;
- der Messschritt und der Speicherschritt werden für wenigstens eine zweite Druckkraft wiederholt durchgeführt.

2. Kalibrierverfahren nach Anspruch 1, **dadurch gekennzeichnet, dass** je Strom wenigstens vier und bevorzugt zehn oder mehr unterschiedliche Auslenkungen angefahren und die Bondkräfte für die unterschiedlichen Auslenkungen mittels der Messeinrichtung bestimmt werden.

3. Kalibrierverfahren nach Anspruch 1 oder 2, **dadurch gekennzeichnet, dass** je Auslenkung wenigstens vier und bevorzugt zehn oder mehr unterschiedliche Ströme für den Kraftaktuator aufgeprägt und die Bondkräfte für die unterschiedlichen Ströme mittels der Messeinrichtung bestimmt werden.

4. Kalibrierverfahren nach einem der Ansprüche 1 bis 3, **dadurch gekennzeichnet, dass** die Aktuatorkraft und/oder die Bondkraft und/oder die Federkraft in einem über dem Strom und der Auslenkung aufgespannten Kennlinienfeld in dem Speicher der Steuerung abgelegt werden.

5. Kalibrierverfahren nach einem der Ansprüche 1 bis 4, **dadurch gekennzeichnet, dass** zum Aufprägen einer der Federkraft entgegenwirkenden Aktuatorkraft das Bondwerkzeug gegen ein Zugwerkzeug mit einem Haken getauscht wird und der Haken in einer an dem Betätigungselement (6) der Messeinrichtung vorgesehene Öse eingehakt wird und dass dann die Auslenkung und der Strom so aufgeprägt werden, dass die Federkraft der Aktuatorkraft entgegenwirkt.

6. Kalibrierverfahren nach einem der Ansprüche 1 bis 5, **dadurch gekennzeichnet, dass** für einen gegebenen Strom des Kraftaktuators und für eine erste und wenigstens eine zweite Auslenkung ein erster und ein zweiter Kraftzunahmewert (m) gebildet werden als Quotient aus der Aktuatorkraft und dem Strom.

7. Kalibrierverfahren nach Anspruch 6, **dadurch gekennzeichnet, dass** für die erste Auslenkung und für die wenigstens eine weitere Auslenkung die Federkräfte bestimmt und gespeichert werden.

8. Vorrichtung zur vollautomatischen oder teilautomatischen Bondkraftkalibrierung eines Bonders mit einem Bondkopf, wobei ein als Teil des Bondkopfs vorgesehenes Bondwerkzeug über eine Feder und einen Kraftaktuator gehalten ist, umfassend eine Kraftmessdose als eine Messeinrichtung (1) zum Bestimmen einer Bondkraft, wobei die Kraftmessdose jedenfalls von einem an dem Bondkopf des Bonders vorgesehenen Bondwerkzeug als Kraftbeaufschlagungskomponente mit einer Druckkraft und bevorzugt mit der Druckkraft und mit einer Zugkraft beaufschlagbar ist umfassend einen datentechnisch mit der Steuerung verbundenen Positionssensor zum Erfassen einer Auslenkung der Feder, umfassend einen datentechnisch mit der Steuerung verbundenen Sensor zum Erfassen eines Stroms des Kraftaktuators und umfassend einen als Teil der Steuerung ausgebildeten Speicher zum Speichern der Messwerte der Kraftmessdose und/oder des Positionssensors und/oder des Stromsensors, **dadurch gekennzeichnet, dass** die Kraftmessdose in einem Arbeitsbereich (10) des Bonders und außerhalb eines Bondbereichs (11) des Bonders montiert ist und dass die Kraftmessdose datentechnisch mit einer Steuerung des Bonders derart verbunden ist, dass Messwerte der Kraftmessdose an die Steuerung des Bonders übertragen und dort weiterverarbeitet und/oder gespeichert werden.

9. Vorrichtung nach Anspruch 8, **dadurch gekennzeichnet, dass** die Kraftmessdose einen von der Bondkraft verformbaren Biegebalken (5) vorsieht.

10. Vorrichtung nach Anspruch 8 oder 9, **dadurch gekennzeichnet, dass** die Kraftmessdose ein Betätigungselement (6) mit einer Kontaktfläche (7) zum Aufprägen der Druckkraft und/oder eine Öse zum Einleiten der Zugkraft aufweist.

**Claims**

1. Calibration method for a bonder comprising a bonding head, a bonding tool provided as part of the bonding head being held via a spring and a force actuator, comprising a current sensor for detecting a current used for driving the force actuator, comprising a position sensor for detecting a deflection of the spring, comprising a control system and comprising a measuring device (1) for determining a bonding force, including the following method steps:

- in a positioning step, positioning the bonding head in a working area (10) and outside a bonding area (11) of the bonder in such a way that the bonding tool is provided above a contact surface (7) of an actuating element (6) of the measuring device (1),
- in a contact step, lowering the bonding head and placing the bonding tool on the contact surface (7) of the measuring device (1);
- in a measurement step, applying a first contact force to the measurement-effective contact area (7) of the measuring device (1), then, at the same time or with a delay, in an at least quasi-static operating state, detecting the bonding force by means of the measuring device, detecting the deflection of the spring by means of the position sensor and detecting the current by means of the current sensor, and determining an actuator force and/or a spring force from the deflection, a spring characteristic curve of the spring, and the bonding force;

- in a storage step, feeding the measured values for the deflection and the current, as well as the bonding force and/or the spring force and/or the actuator force, to a memory assigned to the control system, and storing them there;
- performing the measurement step and the storage step again for at least a second pressure force.

**2.** Calibration method according to claim 1, **characterised in that** for each current at least four, and preferably ten or more, different deflections are initiated and the bonding forces for the various deflections are determined by means of the measuring device.

**3.** Calibration method according to either claim 1 or claim 2, **characterised in that** for each deflection at least four, and preferably ten or more, different currents for the force actuator are applied and the bonding strengths for the different currents are determined by means of the measuring device.

**4.** Calibration method according to any of claims 1 to 3, **characterised in that** the actuator force and/or the bonding force and/or the spring force are stored in a characteristic field, spanning over the current and the deflection, in the memory of the control system.

**5.** Calibration method according to any of claims 1 to 4, **characterised in that**, to apply an actuator force countering the spring force, the bonding tool is replaced with a pulling tool comprising a hook, and the hook is hooked into an eyelet provided on the actuating element (6) of the measuring device, and **in that** then the deflection and the current are applied in such a way that the spring force counteracts the actuator force.

**6.** Calibration method according to any of claims 1 to 5, **characterised in that**, for a given current of the force actuator and for a first and at least a second deflection, a first and a second force gain value (m) are formed as the quotient of the actuator force and the current.

**7.** Calibration method according to claim 6, **characterised in that**, for the first deflection and for the at least one further deflection, the spring forces are determined and stored.

**8.** Device for fully automatic or semi-automatic bonding force calibration of a bonder comprising a bonding head, a bonding tool provided as part of the bonding head being held by a spring and a force actuator, comprising a load cell as a measuring device (1) for determining a bonding force, it being possible for at least a pressure force, and preferably the pressure force and a tensile force, to be applied to the load cell by a bonding tool, provided on the bonding head of the bonder, as a force application component, comprising a position sensor data-linked to the control system for detecting a deflection of the spring, comprising a sensor data-linked to the control system for detecting a current of the force actuator, and comprising a memory, formed as part of the control system, for storing the measured values of the load cell and/or the position sensor and/or the current sensor, **characterised in that** the load cell is mounted in a working area (10) of the bonder and outside a bonding area (11) of the bonder, and **in that** the load cell is data-linked to a control system of the bonder in such a way that measured values of the load cell are transmitted to the control system of the bonder and processed further and/or stored there.

**9.** Device according to claim 8, **characterised in that** the load cell includes a bending beam (5) deformable by the bonding force.

**10.** Device according to either claim 8 or claim 9, **characterised in that** the load cell has an actuating element (6) comprising a contact surface (7) for applying the contact force and/or an eye for introducing the tensile force.

## Revendications

**1.** Procédé d'étalonnage pour un dispositif de liaison doté d'une tête de liaison, dans lequel un outil de liaison prévu comme une partie de la tête de liaison est maintenu par un ressort et un actionneur de force, avec un capteur de courant pour détecter un courant utilisé pour commander l'actionneur de force, avec un capteur de position pour détecter une déviation du ressort, avec une commande et avec un moyen de mesure (1) pour déterminer une force de liaison, comprenant les étapes de procédé suivantes :

- dans une étape de positionnement, la tête de liaison est positionnée dans une zone de travail (10) et à l'extérieur d'une zone de liaison (11) du dispositif de liaison de telle sorte que l'outil de liaison soit prévu au-dessus d'une surface de contact (7) d'un élément d'actionnement (6) du moyen de mesure (1) ;
- dans une étape de contact, la tête de liaison est abaissée et l'outil de liaison est placé sur la surface de contact (7) du moyen de mesure (1) ;
- dans une étape de mesure, une première force de pression est appliquée sur la surface de contact (7) du moyen de mesure (1) efficace du point de vue de la technique de mesure, puis, simultanément ou avec un décalage dans le temps, dans un état de fonctionnement au moins quasistatique, la force de liaison est détectée au moyen du moyen de mesure, la déviation du ressort au moyen du capteur de position et le courant au moyen du capteur de courant et une force de l'actionneur et/ou une force du ressort sont déterminées à partir de la déviation, d'une courbe caractéristique du ressort et de la force de liaison ;
- dans une étape de mémorisation, les valeurs de mesure pour la déviation et le courant d'une part, ainsi que la force de liaison et/ou la force du ressort et/ou la force de l'actionneur d'autre part, sont amenées à une mémoire associée à la commande et y sont mémorisées ;
- l'étape de mesure et l'étape de mémorisation sont exécutées de manière répétée pour au moins une deuxième force de pression.

**2.** Procédé d'étalonnage selon la revendication 1, **caractérisé en ce que**, pour chaque courant, au moins quatre et de préférence dix ou plus déviations différentes sont effectuées et les forces de liaison pour les différentes déviations sont déterminées à l'aide du moyen de mesure.

**3.** Procédé d'étalonnage selon la revendication 1 ou 2, **caractérisé en ce que**, pour chaque déviation, au moins quatre et de préférence dix ou plus courants différents sont appliqués pour l'actionneur de force et les forces de liaison pour les différents courants sont déterminées à l'aide du moyen de mesure.

**4.** Procédé d'étalonnage selon l'une des revendications 1 à 3, **caractérisé en ce que** la force de l'actionneur et/ou la force de liaison et/ou la force du ressort sont enregistrées dans la mémoire de la commande dans un champ de courbes caractéristiques défini en fonction du courant et de la déviation.

**5.** Procédé d'étalonnage selon l'une des revendications 1 à 4, **caractérisé en ce que**, pour appliquer une force de l'actionneur s'opposant à la force du ressort, l'outil de liaison est remplacé par un outil de traction muni d'un crochet et le crochet est accroché dans un oeillet prévu sur l'élément d'actionnement (6) du moyen de mesure, et **en ce que** la déviation et le courant sont ensuite appliqués de telle sorte que la force du ressort s'oppose à la force de l'actionneur.

**6.** Procédé d'étalonnage selon l'une des revendications 1 à 5, **caractérisé en ce que**, pour un courant donné de l'actionneur de force et pour une première et au moins une deuxième déviation, une première et une deuxième valeur d'augmentation de force (m) sont formées comme quotient de la force de l'actionneur et du courant.

**7.** Procédé d'étalonnage selon la revendication 6, **caractérisé en ce que** les forces du ressort sont déterminées et enregistrées pour la première déviation et pour ladite au moins une autre déviation.

**8.** Dispositif pour l'étalonnage automatique ou semi-automatique de la force de liaison d'un dispositif de liaison doté d'une tête de liaison, dans lequel un outil de liaison prévu comme une partie de la tête de liaison est maintenu par un ressort et un actionneur de force, comprenant une cellule de mesure de force comme moyen de mesure (1) pour déterminer une force de liaison, dans lequel la cellule de mesure de force peut en tout cas être soumise à une force de pression, et de préférence à la force de pression et à une force de traction, par un outil de liaison prévu sur la tête de liaison du dispositif de liaison comme composant d'application de force, comprenant un capteur de position relié à la commande par des données pour détecter une déviation du ressort, comprenant un capteur relié par technique de données à la commande pour détecter un courant de l'actionneur de force et comprenant une mémoire réalisée comme une partie de la commande pour mémoriser les valeurs de mesure de la cellule de mesure de force et/ou du capteur de position et/ou du capteur de courant, **caractérisé en ce que** la cellule de mesure de force est montée dans une zone de travail (10) du dispositif de liaison et à l'extérieur d'une zone de liaison (11) du dispositif de liaison et **en ce que** la cellule de mesure de force est reliée par technique de données à une commande du dispositif de liaison de telle sorte que les valeurs de mesure de la cellule de mesure de force sont transmises à la commande du dispositif de liaison et y sont traitées et/ou mémorisées.

**9.** Dispositif selon la revendication 8, **caractérisé en ce que** la cellule de mesure de force présente une poutre de flexion (5) déformable par la force de liaison.

**10.** Dispositif selon la revendication 8 ou 9, **caractérisé en ce que** la cellule de mesure de force présente un élément d'actionnement (6) avec une surface de contact (7) pour l'application de la force de pression et/ou un oeillet pour l'introduction de la force de traction.

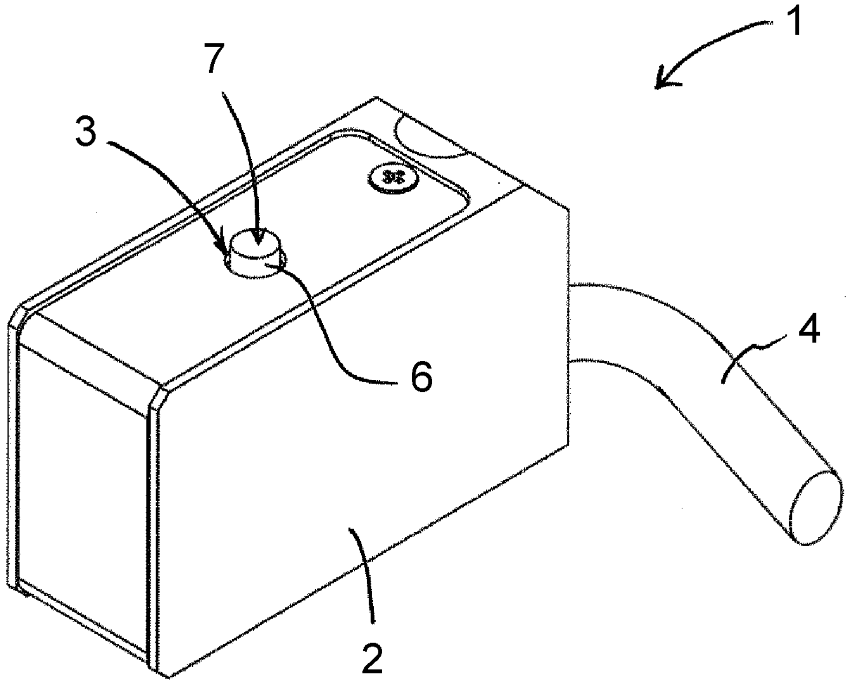


Fig. 1

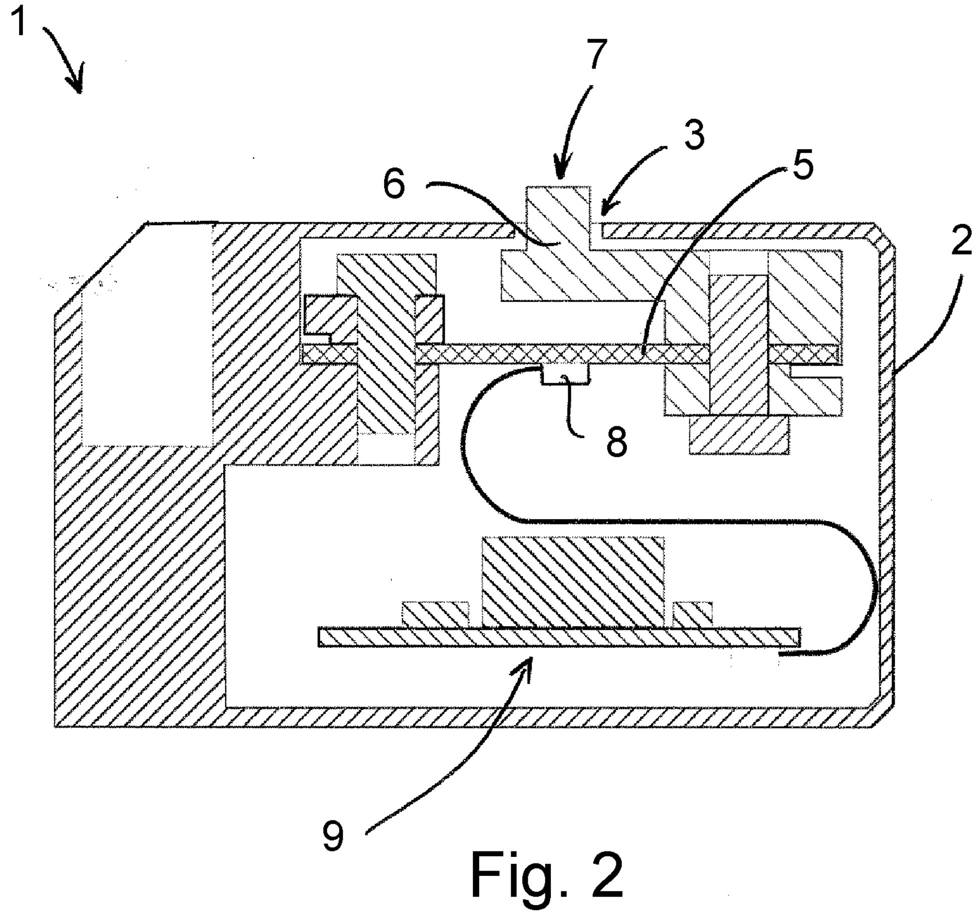


Fig. 2

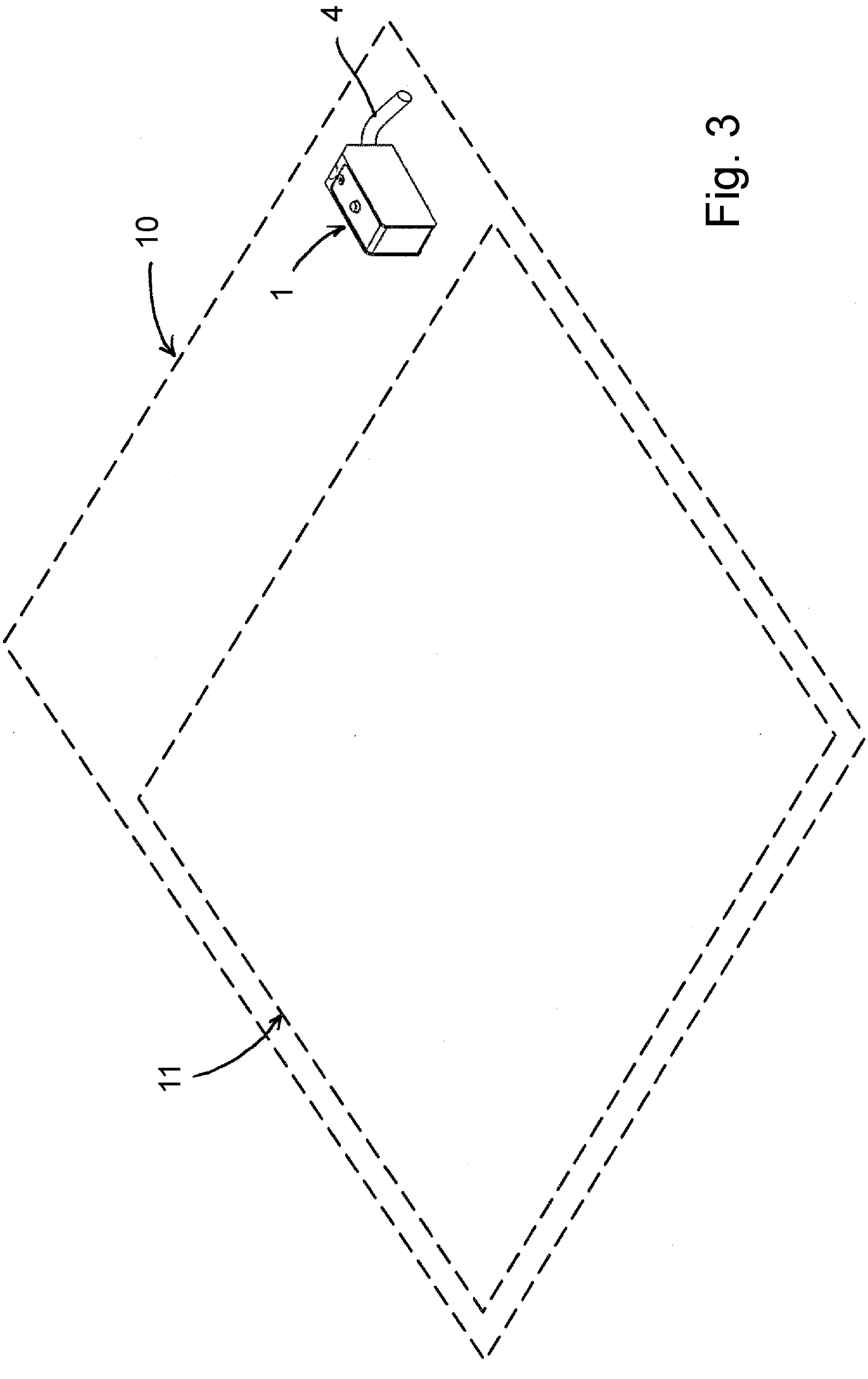


Fig. 3

| | | Strom | | | | | | | | | | | | | | |
|---|---|---|---|---|---|---|---|---|---|---|---|---|---|---|---|---|
| | | i1 | i2 | i3 | i4 | i5 | i6 | i7 | i8 | i9 | i10 | i11 | i12 | i13 | i14 | $F_{Feder}(z)$ |
| Auslenkung | z1 | F1-1 | F2-1 | F3-1 | F4-1 | F5-1 | F6-1 | F7-1 | F8-1 | F9-1 | F10-1 | F11-2 | F12-1 | F13-1 | F14-1 | $F_{Feder}1$ |
| | z2 | F1-2 | F2-2 | F3-2 | F4-2 | F5-2 | F6-2 | F7-2 | F8-2 | F9-2 | F10-2 | F11-3 | F12-2 | F13-2 | F14-2 | $F_{Feder}2$ |
| | z3 | F1-3 | F2-3 | F3-3 | F4-3 | F5-3 | F6-3 | F7-3 | F8-3 | F9-3 | F10-3 | F11-4 | F12-3 | F13-3 | F14-3 | $F_{Feder}3$ |
| | z4 | F1-4 | F2-4 | F3-4 | F4-4 | F5-4 | F6-4 | F7-4 | F8-4 | F9-4 | F10-4 | F11-5 | F12-4 | F13-4 | F14-4 | $F_{Feder}4$ |
| | z5 | F1-5 | F2-5 | F3-5 | F4-5 | F5-5 | F6-5 | F7-5 | F8-5 | F9-5 | F10-5 | F11-6 | F12-5 | F13-5 | F14-5 | $F_{Feder}5$ |
| | z6 | F1-6 | F2-6 | F3-6 | F4-6 | F5-6 | F6-6 | F7-6 | F8-6 | F9-6 | F10-6 | F11-7 | F12-6 | F13-6 | F14-6 | $F_{Feder}6$ |
| | z7 | F1-7 | F2-7 | F3-7 | F4-7 | F5-7 | F6-7 | F7-7 | F8-7 | F9-7 | F10-7 | F11-8 | F12-7 | F13-7 | F14-7 | $F_{Feder}7$ |
| | z8 | F1-8 | F2-8 | F3-8 | F4-8 | F5-8 | F6-8 | F7-8 | F8-8 | F9-8 | F10-8 | F11-9 | F12-8 | F13-8 | F14-8 | $F_{Feder}8$ |
| | z9 | F1-9 | F2-9 | F3-9 | F4-9 | F5-9 | F6-9 | F7-9 | F8-9 | F9-9 | F10-9 | F11-10 | F12-9 | F13-9 | F14-9 | $F_{Feder}9$ |
| | z10 | F1-10 | F2-10 | F3-10 | F4-10 | F5-10 | F6-10 | F7-10 | F8-10 | F9-10 | F10-10 | F11-11 | F12-10 | F13-10 | F14-10 | $F_{Feder}10$ |
| | z11 | F1-11 | F2-11 | F3-11 | F4-11 | F5-11 | F6-11 | F7-11 | F8-11 | F9-11 | F10-11 | F11-12 | F12-11 | F13-11 | F14-11 | $F_{Feder}11$ |
| | z12 | F1-12 | F2-12 | F3-12 | F4-12 | F5-12 | F6-12 | F7-12 | F8-12 | F9-12 | F10-12 | F11-13 | F12-12 | F13-12 | F14-12 | $F_{Feder}12$ |
| | z13 | F1-13 | F2-13 | F3-13 | F4-13 | F5-13 | F6-13 | F7-13 | F8-13 | F9-13 | F10-13 | F11-14 | F12-13 | F13-13 | F14-13 | $F_{Feder}13$ |
| | z14 | F1-14 | F2-14 | F3-14 | F4-14 | F5-14 | F6-14 | F7-14 | F8-14 | F9-14 | F10-14 | F11-15 | F12-14 | F13-14 | F14-14 | $F_{Feder}14$ |

Fig. 4

| | | m(z) | $F_{Feder}(z)$ |
|---|---|---|---|
| Auslenkung | z1 | m1 | $F_{Feder}1$ |
| | z2 | m2 | $F_{Feder}2$ |
| | z3 | m3 | $F_{Feder}3$ |
| | z4 | m4 | $F_{Feder}4$ |
| | z5 | m5 | $F_{Feder}5$ |
| | z6 | m6 | $F_{Feder}6$ |
| | z7 | m7 | $F_{Feder}7$ |
| | z8 | m8 | $F_{Feder}8$ |
| | z9 | m9 | $F_{Feder}9$ |
| | z10 | m10 | $F_{Feder}10$ |
| | z11 | m11 | $F_{Feder}11$ |
| | z12 | m12 | $F_{Feder}12$ |
| | z13 | m13 | $F_{Feder}13$ |
| | z14 | m14 | $F_{Feder}14$ |

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6119917 A
- KR 20000066062 A
- JP 2002118136 A